# EUROPÄISCHE PATENTSCHRIFT

(11) **EP 1 889 681 B1**
(45) Veröffentlichungstag und Bekanntmachung des Hinweises auf die Patenterteilung: **17.12.2008**
(21) Anmeldenummer: 06090139.4
(22) Anmeldetag: 17.08.2006
(51) Int. Cl.: B23K 20/02, B23K 20/227, B23K 20/233, F28F 3/02, F28F 3/08, B81B 7/00, B81C 3/00

(54) **Verfahren zum Fügen von Werkstücken aus Edelstahl, Nickel oder Nickellegierungen unter Verwendung einer aus einer Nickel-Phosphorus-Legierung bestehenden Fügeschicht ; Verfahren zum Herstellen eines mikrostrukturierten Bauteils unter Verwendung eines solchen Verfahren**
Process of joining workpieces made of stainless, Nickel or Nickel alloys using a joining layer made from a Nickel-Phosphor alloy ; Process of manufacturing a micro workpiece using such a process
Procédé de fabrication de pièces en acier inoxydable, nickel ou alliages de nickel utilisant une couche de liaison en alliage de Nickel-Phosphore ; Procédé de fabrication d'un micro-élément mettant en oeuvre un tel procédé

(43) Veröffentlichungstag der Anmeldung: 20.02.2008
(73) Patentinhaber: ATOTECH Deutschland GmbH, 10553 Berlin (DE)
(72) Erfinder: Herber, Ralph Dr.,, 12305 Berlin (DE); Kurtz, Olaf, Dr.,, 10627 Berlin (DE); Etzkorn, Johannes Dr.,, 13581 Berlin (DE); Madry, Christian, 13053 Berlin (DE); Schwiekendick, Carsten, 13599 Berlin (DE); Schäfer, Gerd Dr.,, 12045 Berlin (DE)
(74) Vertreter: Bressel, Burkhard

(56) Entgegenhaltungen:
- EP-A1- 1 136 782
- DE-A1-5102005 032 11
- DE-C1- 19 801 374
- JP-A- 2 121 782
- US-A- 5 964 398
- US-A1- 2003 189 087
- US-A1- 2004 013 585
- US-A1- 2004 232 211

## Beschreibung

Die vorliegenden Erfindung betrifft ein Verfahren zum Fügen von mindestens zwei Werkstücken aus Edelstahl, Nickel oder Nickellegierungen gemäß dem Oberbegriff des Anspruchs 1 (siehe, z.B. EP-A1-1 136 782) und ein Verfahren zum Herstellen eines mikrostrukturierten Bauteils, ausgewählt aus der Gruppe, umfassend Mikroreaktoren, Mikrowärmetauscher, Mikrokühler und Mikromischer (siehe Anspruch 21). Ein mikrostrukturiertes Bauteil ist ein Bauteil mit Fluidstrukturen, umfassend einen Stapel von mikrostrukturierten Bauteillagen aus Edelstahl, Nickel oder Nickellegierungen, die miteinander verbunden sind.

### Stand der Technik:

Nickellegierungen umfassen u.a. Nickel/Chrom-Legierungen, die weniger als 50% Eisen enthalten. Diese Legierungen werden nicht mehr zu den Stählen gezählt, sondern zu den sogenannten Superlegierungen. Sie zeichnen sich durch eine besondere Korrosionsstabilität und Warmfestigkeit aus (sogenannte hochwarmfeste Legierungen) und basieren auf dem erstmals im Jahre 1906 beschriebenen Legierungstyp NiCr8020 (Zusammensetzung: 80 Gew.-% Nickel, 20 Gew.-% Chrom). Durch Zusätze wie Aluminium, Titan, Molybdän, etc. können Eigenschaften, wie die Temperaturfestigkeit und Härte, weiter positiv beeinflusst werden. Moderne Handelsnamen der Superlegierungen sind z.B. Inconel^{®} (Marke von Huntington Alloys Canada, CA), Incoloy^{®} (Marke von Huntington Alloys Canada, CA), Hastelloy^{®} (Marke von Haynes International, US), Cronifer^{®} (Marke von ThyssenKrupp VDM, DE) und Nicrofer^{®} (Marke von ThyssenKrupp VDM, DE). Die Superlegierungen werden insbesondere in der Luft- und Raumfahrtechnik, der Kraftwerksindustrie (beispielsweise für Gasturbinen), der Öl- und Gasindustrie sowie der chemischen Verfahrenstechnik eingesetzt, d.h. für Anwendungen, in denen Festigkeit bei hohen Temperaturen und hoch korrosiven Bedingungen gewährleistet sein muss.

Die Fertigung von mikrostrukturierten Bauteilen, insbesondere aus den oben genannten Nickellegierungen, stellt hohe Anforderungen an die Prozessführung. Üblicherweise sind zwei verschiedene Fertigungswege beschrieben worden: Schweißverfahren, wie Thermodiffusionsschweißen, Lichtbogenschweißen, Elektronenstrahlschweißen, Laserschweißen sowie Lötverfahren, wie das Löten mit Silberbasislot für Temperaturanwendungen bis 371 °C und das Löten mit Nickelbasislot für Hochtemperaturanwendungen. In der Regel handelt es sich hierbei um ternäre und quartäre Systeme, die als Pulver, Wachs, Paste oder Folie angeboten und verwendet werden.

Zur Herstellung metallischer mikrostrukturierter Bauteile ist das Thermodiffusionsschweißverfahren als Fügetechnik für die zu verbindenden Metallfolien verbreitet, da die alternativ genannten Schweißverfahren keine Möglichkeit bieten, einen vollständigen Verbund der hierfür nutzbaren Flächen auf den Folien zu bilden. Bei diesen Verfahren ist die Wärmeeinbringung und damit der erreichbare Verbund der Folien miteinander lokal begrenzt, so dass sich im Gefüge des Grundmaterials leicht Risse bilden können und sich das Grundmaterial durch lokale Überhitzung verformen bzw. verziehen kann. Dies führt zu einem Verlust der Maßhaltigkeit des Bauteils. Hinzu kommt, dass eine thermische Kopplung der einzelnen Lagen untereinander nicht im möglichen Maße hergestellt ist. Gerade diese Anforderung ist aber ein wichtiger Grund für die Verwendung von mikrostrukturierten Bauteilen in der Wärme-, Prozess-und chemischen Verfahrenstechnik, da nur über eine thermische Kopplung der einzelnen Lagen untereinander Isothermie im Bauteil und genaueste Temperaturkontrolle in chemischen Prozessen und Reaktionen gewährleistet werden kann. Ein hierzu vorausgesetzter flächiger Verbund kann in der Schweißtechnik nur mit Hilfe des Thermodiffusionsschweißverfahrens hergestellt werden. Bei diesem Verfahren wird der zu fügende Blechstapel aus einzelnen mikrostrukturierten Bauteillagen, insbesondere Folien, unter sehr hohem Druck, bei sehr hoher Temperatur und gleichzeitig bei während der Dauer des gesamten Verfahrens erzeugtem Hochvakuum über reine Festkörperdiffusion miteinander verbunden.

Der Vorteil des Diffusionsschweißverfahrens besteht vor allem darin, dass durch reine Festkörperdiffusion der Grundmaterialbestandteile monolithische Bauteile erzeugt werden. Darunter ist zu verstehen, dass eine Fügeschicht nach dem Fügeverfahren in einem Querschliff nicht mehr erkennbar ist, d.h. dass keine Fügenaht mehr sichtbar gemacht werden kann. Dies führt dazu, dass sich der Bereich, in dem sich eine Fügeschicht vor dem Fügeverfahren befunden hat, nach Durchführung des Verfahrens nicht mehr oder nicht mehr wesentlich vom Grundmaterial unterscheidet und somit im Wesentlichen die gleichen Eigenschaften hat wie das Grundmaterial.

Um eine Interdiffusion (Diffusion von Bestandteilen zwischen unterschiedlichen Bauteilkomponenten, z.B. zwischen Fügeschicht und Bauteillage) zwischen den zu fügenden Komponenten zu bewerkstelligen, sind beim Diffusionsschweißen eine sehr hohe Temperatur, ein sehr hoher Anpressdruck (z.B. 20 MPa, D. Brandon, W. Kaplan in Joining Processes - An Introduction, Chichester, 1997, S. 260) sowie Hochvakuum zur Vermeidung der Bildung von Oxidschichten im Fügebereich erforderlich. Darüber hinaus werden sehr hohe Anforderungen an die Oberflächengüte der zu fügenden Bauteilkomponenten, insbesondere hinsichtlich Rauheit, Sauberkeit der Oberfläche, sowie Formgenauigkeit/Planarität, gestellt. Zusätzlich gibt es Restriktionen bei der Materialauswahl und der Materialkombination, da in aller Regel mit Anforderungen an die Temperaturstabilität des Grundmaterials auch die erforderliche Minimaltemperatur beim Diffusionsschweißen ansteigt.

Insbesondere bei hochwarmfesten Materialien wird der apparative Aufwand beim Diffusionsschweißen schnell unverhältnismäßig hoch. Das betrifft nicht nur die Temperaturerzeugung selbst und die Anlagengröße (Öfen), sondern insbesondere die Erzeugung eines gleichmäßigen Anpressdrucks auf die Bauteillagen. Wenn wegen der hohen erforderlichen Temperatur konventionelle Pressstempel nicht mehr einsetzbar sind, muss mit Spannvorrichtungen gearbeitet werden. Die Druckerzeugung mit Spannvorrichtungen beruht auf dem Prinzip der unterschiedlichen thermischen Ausdehnungskoeffizienten. Während diese Methode bei kleinen Bauteilen von wenigen Zentimetern Kantenlänge noch beherrschbar ist, werden die Schwierigkeiten bei größeren Bauteilen sehr schnell unüberwindbar. Der Grund dafür ist, dass es nicht mehr gelingt, die unbedingt erforderliche gleichmäßige Verteilung des Anpressdrucks über das gesamte Bauteil zu erreichen. Mögliche Folgen sind Deformationen schmaler Stege zwischen Kanälen in den Bauteillagen, Verzug des Bauteils und Lecks.

Der apparative Aufwand ist durch die Kombination aus sehr hoher Temperatur, Druck und Hochvakuum groß und mit einer Vielzahl technischer Probleme (keine geeigneten kommerziellen Anlagen (Hochtemperaturpresswerkzeuge)) verbunden. Damit ist dieses Verfahren unter wirtschaftlichen Aspekten nicht zu rechtfertigen.

Aus diesen Gründen sind Lötverfahren als Alternative für die Herstellung von mikrostrukturierten Bauteilen vorgeschlagen worden (DE 198 01 374 C1). Allerdings haben Lötverfahren immer den grundsätzlichen Nachteil, dass das Lot als Fügeschicht zwischen den zu fügenden Bauteillagen aus einem anderen Material besteht als die gestapelten Lagen. Durch das Lot werden also Fremdmaterialien eingebracht, die die Eigenschaften des Grundmaterials, wie Festigkeit und Korrosionsanfälligkeit bzw. -beständigkeit, verändern und negativ beeinflussen können. Ursache hierfür ist unter anderem die Bildung intermetallischer Phasen während des Lötprozesses, deren Anzahl, Größe und Verteilung die Eigenschaften des Grundmaterials und damit die des gefügten Bauteils nachhaltig negativ beeinflussen können. Die Lotbestandteile müssen daher entsprechend den Zusammensetzungen der Grundmaterialien und den gewählten Lötbedingungen angepasst sein. Jedenfalls werden bei derartigen Verfahren keine monolithischen Bauteile erzeugt, d.h. mit Fügeverbindungen, deren Nähte auch in einem Querschliff nicht mehr erkennbar sind.

Beim Hochtemperaturlöten, insbesondere bei Verwendung von Nickelbasisloten, stellt die Bildung von spröden Hartphasen eine besondere Gefahr dar. So können Zusätze von Phosphor, Bor und Kohlenstoff zur Bildung und Stabilisierung vergleichsweise großer Mengen an Sprödphasen und damit zur Herabsetzung der Duktilität und Festigkeit sowie der Korrosionsbeständigkeit der Grundwerkstoffe führen. Phosphor bildet mit den Übergangsmetallen Chrom, Eisen und Nickel sehr spröde und hochschmelzende intermetallische Me₃P-Phasen (Phosphide) im Lotgefüge. Zentraler Bestandteil vieler Nickelbasislote sind aber gerade die zulegierten Metalloide Bor, Silizium und Phosphor, da durch sie die hohen Schmelzpunkte der Nickel-und Nickel/Chrom-Lote auf beherrschbare Prozesstemperaturen abgesenkt werden. Hinzu kommen positive Auswirkungen auf das Benetzungs- und Fließverhalten der Lote sowie deren kapillares Spaltfüllvermögen.

Durch eine lange Lötdauer oder anschließendes Tempern bzw. Nachglühen werden Feststoffdiffusion der gebildeten Hartphasen und damit deren Auflösung im Grundmaterial gefördert. Diese Verfahrensweise ist in jedem Falle mit erheblichen Mehrkosten verbunden, und nachteilige Auswirkungen, wie Auflegieren des Grundwerkstoffes oder eine Grobkornbildung, müssen unbedingt vermieden werden. Hinzu kommt, dass die Vollständigkeit der Auflösung der gebildeten Sprödphasen nicht zerstörungsfrei überprüft werden kann und dass die Grundwerkstoffe der hohen Temperatur über den Lötprozess hinaus ausgesetzt werden müssen.

Deshalb wird bei moderner Prozessführung versucht, diese "Diffusionsglühbehandlung" zu vermeiden und bereits durch eine optimierte Abstimmung der Lot/Grundwerkstoff-Kombination und der Prozessparameter eine weitgehend sprödphasenfreie Fügezone zu erzeugen. Ziel ist es, einen so schmalen Lötspalt zu bilden, dass die Lötspaltbreite unterhalb der sich aus dieser Abstimmung ergebenden kritischen Lötspaltbreite (KLB) im gefügten Bauteil liegt. Die KLB gibt an, bei welcher Lötspaltbreite eine weitgehend sprödphasenfreie Lötnaht zu erwarten ist. Für den Einsatz von Nickelbasisloten gilt als Faustformel KLB < 50 µm, für phosphorhaltige Nickelbasislote KLB < 10 µm.

Beispielsweise geben W. Müller, J-U. Müller, in: Löttechnik- Leitfaden für die Praxis, Düsseldorf, 1995, Seiten 167-170, an, dass durch eine Wärmenachbehandlung bzw. Spaltminimierung bei Verwendung phosphorhaltiger Nickelbasislote keine nennenswerte Verbesserung der Zähigkeit erzielt werden könne. Die Diffusionskoeffizienten der Kombinationen Phosphor/Grundwerkstoff seien so klein, dass die kritischen Lötspaltbreiten weit unterhalb 10 µm liegen und in der Praxis kaum zu verwirklichen seien. Die mit phosphorhaltigen Nickelbasisloten hergestellten Bauteile würden sich deshalb weniger für dynamische Belastungen eignen.

Lötverfahren bieten aber unter fertigungstechnischen und Kostengesichtspunkten einige grundsätzliche Vorteile, wie die Möglichkeit der Verwendung industriell hergestellter Pressen, die Möglichkeit, auch Bauteillagen mit geringer Oberflächengüte miteinander verbinden zu können, unterschiedliche Werkstoffe miteinander zu kombinieren und örtliche Überhitzung und Rissbildung im Grundwerkstoff zu vermeiden. Des Weiteren können zahlreiche Fügebereiche an einem Bauteil und damit auch großflächige Bauteile, die aus mehreren einzelnen funktionellen Lagen bestehen, in einem Prozessschritt gefügt werden. Obwohl Lötverfahren schon mehrfach als Fügeverfahren für mikrostrukturierte Bauteile vorgeschlagen worden sind, ist es bislang nicht gelungen, konventionelle Lötverfahren zur industriellen Herstellung von derartigen Bauteilen einzusetzen, da bei deren Herstellung gegenüber dem Diffusionsschweißverfahren zusätzliche Anforderungen erfüllt werden müssen: Zum einen darf kein Lot beim Schmelzen in die mikrostrukturierten Kanäle in den Bauteillagen mit der Folge gelangen, dass die Kanäle verstopfen. Im Gegensatz zu vielen Lötverfahren soll zum anderen auch unbedingt ohne Flussmittel gearbeitet werden, da Flussmittelrückstände aus dem fertigen Bauteil nicht oder nur mit erheblichem Aufwand wieder entfernt werden können. Flussmittelrückstände sind nicht nur unerwünschte Verunreinigungen im Reaktor, sondern auch die Ursache von Korrosion. Besonders kritisch sind hier die Lotnähte an schmalen Stegen in den Bauteillagen.

Dies ist der Grund, weshalb bislang Bauteile aus Nickel, Nickellegierungen oder Edelstahl bevorzugt geschweißt werden. Alternativ wird vorgeschlagen, Lotpasten zum Fügen zu verwenden, die insbesondere frei von Phosphor sein sollen. Solche Lote bestehen beispielsweise aus Legierungen, die Gold, Cadmium, Zink und Kupfer enthalten, und sind in: Corrosion Resistant Alloys, Haynes International, Inc. 2003, Seite 16, beschrieben, um Hastelloy^{®}-Legierungen zu fügen.

Aus den vorstehenden Ausführungen wird deutlich, dass der Fachmann zum Fügen von Edelstählen, Nickel oder Nickellegierungen aufgrund der beschriebenen Nachteile keine Fügeschichten aus Nickel-Phosphorlegierungen einsetzen würde.

Beim klassischen Löten wird in Abhängigkeit von der Fügetemperatur zwischen dem Weichlöten (T_{f} < 450°C, T_{f}: Fügetemperatur), Hartlöten (450°C < T_{f} < 1100°C) und dem Hochtemperaturlöten (T_{f} > 950°C) als Spezialfall des Hartlötens unterschieden. In den verschiedenen Temperaturbereichen kommen dabei unterschiedliche Lotwerkstoffe zum Einsatz. Deren jeweilige Schmelzbereiche liegen mehr oder weniger deutlich unter dem des zu fügenden Grundmaterials. Beim Erreichen der Löttemperatur schmilzt das Lot auf, benetzt die Oberflächen der zu verbindenden Werkstücke und bewirkt nach dem Erkalten deren haftfeste Verbindung. Die so gebildete Lotschicht besteht somit beim klassischen Löten immer aus einem anderen Material als die Werkstücke. Die daraus resultierenden unterschiedlichen physikalischen Eigenschaften des Lotes einerseits und des Grundwerkstoffes andererseits, etwa unterschiedliche thermische Ausdehnungskoeffizienten, unterschiedliche elektrochemische Potentiale und das sich daraus ergebende unterschiedliche Korrosionsverhalten, unterschiedliche Gefüge sowie die unterschiedliche Härte und Duktilität sind grundsätzliche, aber je nach Anwendung und Einsatzgebiet des Bauteils mehr oder auch weniger schwerwiegende, d.h. akzeptable Nachteile.

Ein Verfahren, das sich zum Löten von mikrostrukturierten Blechen eignet, ist in DE 198 01 374 C1 beschrieben. Dieses Verfahren weist folgenden Ablauf auf: Erzeugen eines Stapels aus den Blechen und Lotschichten, die jeweils zwischen zwei benachbarten Blechen vorhanden sind, wobei die Schichtdicke der Lotschichten 3 - 25 µm beträgt, und Verlöten des Stapels im Vakuum oder in Inertatmosphäre unter Wärmeeintrag. Für die Lotschicht werden beispielsweise NiP- (Nickel/Phosphor) Legierungen mit 7 - 14 Gew.-% Phosphoranteil vorgeschlagen. Die Lotschicht kann u.a. galvanisch auf die Bleche aufgebracht werden. Die Löttemperatur liegt im Bereich von 720 bis 1280°C. Dieses Verfahren führt nicht zu monolithischen Bauteilen, sondern zur Ausbildung von Fügezonen wie beim klassischen Löten mit der entsprechenden Gefahr einer Ausbildung spröder Hartphasen. Dies bedingt die bereits genannten Nachteile.

Weiterhin ist aus EP-A1-1 136 782 ein Plattenwärmeaustauscher mit Anschlussmitteln zum Einlass und Auslass von Fluiden bekannt, der Endplatten und mehrere dazwischen angeordnete Platten mit Flüssigkeitsdurchführungen aufweist. Die Platten bestehen aus Edelstahl und werden zum Fügen beispielsweise mit einer Schicht aus Nickel/Phosphor stromlos beschichtet.

Weiterhin ist in US 2004/0013585 A1 ein Mikrowärmeaustauscher beschrieben, der aus Platten mit Kanälen gebildet ist, die aus Edelstahl oder Nickelbasislegierung bestehen. Die einzelnen Platten werden unter Verwendung einer Natriumhypophosphit enthaltenden Lösung mit einer Nickelschicht stromlos beschichtet, um sie miteinander zu fügen.

Die grundsätzlichen Probleme, die sich bei Anwendung eines Lötverfahrens durch die Materialunterschiede zwischen der Fügeschicht und dem Grundmaterial ergeben, können bei monolithisch gefügten Bauteilen naturgemäß nicht auftreten. Ein monolithisches Gefüge kann erzeugt werden, wenn bei genügend hoher Temperatur gefügt wird, so dass Komponenten der Fügeschicht und des Grundmaterials ineinander diffundieren und die zunächst entstandenen Konzentrationsgradienten der vorhandenen Elemente nach und nach verschwinden (G.J.Humpston, D.M.Jacobson, in: *Principles of Soldering and Brazing*, ASM International, 4th Printing, Materials Park, OH, April 2001, ISBN 0-87170-462-5, Seite 129). Monolithische Bauteile werden daher im Allgemeinen nur über die bereits diskutierten schwierigen, technisch sehr aufwändigen und kostenintensiven Hochtemperaturfügeverfahren, wie das Diffusionsschweißverfahren, erhalten.

US 6,672,502 B1 betrifft ein Verfahren zum Herstellen einer monolithischen intermetallischen Struktur. Das Verfahren umfasst die Verfahrensschritte: Bereitstellen von Platten, die aus ersten und zweiten Metalllagen bestehen, Strukturieren der Platten, Stapeln und Registrieren der strukturierten Platten, Verbinden mehrerer Platten in dem Stapel und Verarbeiten des Stapels unter Bildung einer intermetallischen Struktur. Als Metalllagen werden beispielsweise Aluminium- und Nickel-Lagen verwendet. Diese werden gegebenenfalls mit einem geeigneten Verfahren strukturiert und dann oder bereits zuvor gestapelt. Beim nachfolgenden Verarbeiten des Stapels unter Bildung der intermetallischen Struktur wird ein monolithisches intermetallisches Gefüge gebildet. Allerdings sind die gefügten Bauteile außerordentlich spröde, da die dabei gebildete Struktur aus einer intermetallischen Phase besteht. Hierzu werden mehrere Platten aus unterschiedlichen Metallen in stöchiometrischem Mengenverhältnis kombiniert und miteinander gefügt. Daher weist der gebildete Verbund unbefriedigende Materialeigenschaften, insbesondere eine geringe mechanische Festigkeit bei dynamischer Belastung, auf.

Weiterhin ist in Patent Abstracts of Japan zu JP 02121782 ein Verfahren zum Aufbringen einer Fügeschicht, die u.a. Nickel und Phosphor enthalten kann, auf strukturierte Metalllagen beschrieben. Das Fügeverfahren ist ein Flüssigkeitsdiffusionsfügeverfahren.

### Zusammenfassung der Erfindung:

Vor diesem Hintergrund besteht eine Aufgabe der vorliegenden Erfindung darin, ein Verfahren zum Fügen von Werkstücken aus Edelstahl, Nickel oder Nickellegierungen zu finden.

Eine weitere Aufgabe der Erfindung besteht darin, ein Verfahren zum Fügen der Werkstücke zu finden, das kostengünstig durchführbar ist.

Eine weitere Aufgabe der vorliegenden Erfindung besteht darin, ein Verfahren zum Fügen der Werkstücke zu finden, bei dem die vorteilhaften Eigenschaften des Edelstahl-, Nickel- oder Nickellegierungsmaterials erhalten bleiben.

Noch eine weitere Aufgabe der vorliegenden Erfindung besteht darin, die Nachteile der Schweißverfahren zu vermeiden, insbesondere deren hohe Kosten und hoher apparativer Aufwand.

Noch eine weitere Aufgabe der vorliegenden Erfindung besteht darin, ein Verfahren zum Fügen von mikrostrukturierten Werkstücken zu finden und insbesondere zu vermeiden, dass Mikrostrukturen in den zu fügenden Bauteilen nicht durch Lotmaterial der Fügeschicht verstopft werden.

Noch eine weitere Aufgabe der vorliegenden Erfindung besteht darin, ein Verfahren zum Herstellen eines mikrostrukturierten Bauteils zu finden.

Diese Aufgaben werden gelöst durch das Verfahren zum Fügen von mindestens zwei Werkstücken aus Edelstahl, Nickel oder Nickellegierungen nach Anspruch 1 und das Verfahren zum Herstellen eines mikrostrukturierten Bauteils nach Anspruch 21. Bevorzugte Ausführungsformen der Erfindung sind in den Unteransprüchen angegeben.

In der vorliegenden Anmeldung steht der Begriff "Werkstück" für ein Bauelement, das eine für eine beabsichtigte Anwendung geeignete Form hat, beispielsweise eine Platte, Folie oder ein Blech. Die Werkstücke bestehen erfindungsgemäß aus Edelstahl oder Nickel oder einer Nickellegierung. Werden mehrere Werkstücke miteinander zu einem Bauteil kombiniert und gefügt, so können die miteinander kombinierten Werkstücke aus gleichen oder unterschiedlichen Materialien bestehen. Beispielsweise können Werkstücke aus verschiedenen Nickellegierungen miteinander kombiniert und gefügt werden.

In der vorliegenden Anmeldung steht der Begriff "Bauteil" für ein Produkt, das aus mehreren Werkstücken durch Fügen gebildet wird. Das Bauteil selbst kann ein Fertigprodukt oder ein Halbprodukt sein. Beispielsweise kann das Bauteil ein Halbprodukt zur Herstellung eines Mikroreaktors, Mikrowärmetauschers oder Mikromischers sein.

In der vorliegenden Anmeldung steht der Begriff "mikrostrukturierte Bauteile" für solche Bauteile, die Strukturen aufweisen, vor allem Fluidstrukturen. Diese Strukturen weisen eine Tiefe im Bereich von 50 - 10000 µm, insbesondere von 50 - 2500 µm auf. Derartige Bauteile werden insbesondere als mikrostrukturierte Reaktoren (Mikroreaktoren), Mischer (Mikromischer) und Wärmetauscher (Mikrowärmetauscher) eingesetzt.

In der vorliegenden Anmeldung steht der Begriff "Mikroreaktor, Mikromischer und Mikrowärmetauscher" für mikrostrukturierte Bauteile, die Kanalstrukturen für Fluide aufweisen. Die Mikrowärmetauscher weisen zwei voneinander getrennte Kanalstruktursysteme auf, zwischen denen keine Fluidverbindung besteht, die aber in engem thermischem Kontakt stehen, so dass Wärme von in einem Kanalsystem fließendem Fluid zu Fluid in dem anderen Kanalsystem gelangen kann. Bekannt sind z.B. Kreuzwärmetauscher, die kreuzweise übereinander angeordnete Kanalstrukturen aufweisen, die alternierend den beiden Kanalsystemen angehören. Mikromischer weisen üblicherweise nur ein Kanalsystem auf: Mindestens zwei Fluide, die über jeweilige Einlässe in den Mischer eintreten, gelangen in ein Mischkammersystem und werden dort gemischt. Das gemischte Fluid gelangt über einen einzigen Auslass aus dem Mischer heraus. Mikroreaktoren weisen ebenfalls üblicherweise nur ein derartiges Kanalsystem auf. Die Reaktoren können u.a. auch Mikromischer und Mikrowärmetauscher enthalten, um Reaktanten zu mischen bzw. vorzuheizen oder vorzukühlen oder nachträglich zu heizen oder zu kühlen. Gegebenenfalls gemischte und gegebenenfalls aufgeheizte oder abgekühlte Reaktanten werden in einem Reaktionsraum chemisch umgesetzt. Die genannten Bauteile können weitere Elemente, wie Sensoren, Aktoren sowie Heiz- und Kühlelemente enthalten. Alle erwähnten Kanalstrukturen weisen die für mikrostrukturierte Bauteile erwähnten Dimensionen auf. Mikroreaktoren, Mikrowärmetauscher und Mikromischer werden vor allem in der Chemie, u.a. in der chemischen Technik, beispielsweise Medizintechnik und chemischen Reaktionstechnik, sowie in der Kraftfahrzeugtechnik eingesetzt.

In der vorliegenden Anmeldung steht der Begriff "Vertiefungen" für Ausnehmungen in den Werkstücken, insbesondere in den Folien oder Blechen, die für die Bildung von Kanälen lang gestreckt sind und die Werkstücke nicht vollständig durchsetzen, und für Perforationen, die die Werkstücke für die Bildung von Durchlässen zwischen verschiedenen Lagen vollständig durchsetzen. Andere Vertiefungen und Perforationen sind ebenfalls möglich, beispielsweise nicht lang gestreckte, die Werkstücke nicht vollständig durchsetzende Ausnehmungen oder lang gestreckte (die Werkstücke vollständig durchsetzende) Perforationen. Die Durchführungen werden beim Stapeln von mikrostrukturierten Lagen aus den darin enthaltenen Vertiefungen gebildet.

In der vorliegenden Anmeldung steht der Begriff "Durchführungen" für Fluidströmungswege in einem mikrostrukturierten Bauteil, die sich entweder innerhalb einer Bauteillage (Kanäle) oder die Bauteillage durchsetzend (Verbindungskanäle) erstrecken. Andere Durchführungen sind ebenfalls möglich, beispielsweise Mischkammern und Reaktionskammern.

In der vorliegenden Anmeldung steht der Begriff "Fluid" für eine Flüssigkeit oder ein Gas.

In der vorliegenden Anmeldung steht der Begriff "elektrolytisches Metallabscheideverfahren" für ein Verfahren zum Herstellen einer Metallschicht auf einer Unterlage mit einem nasschemischen (galvanotechnischen) Verfahren, bei dem die Metallschicht aus einer chemischen Behandlungsflüssigkeit, beispielsweise einer Lösung, Suspension oder Dispersion, unter Anwendung eines elektrischen Stromes zwischen der Unterlage und einer Gegenelektrode (Anode) auf der Werkstückoberfläche gebildet wird. Beispielsweise kann Kupfer aus einer schwefelsauren Kupfersulfatlösung elektrolytisch abgeschieden werden. Gleichfalls können auch andere Metalle und Metalllegierungen abgeschieden werden, beispielsweise Nickel, Kobalt, Chrom, Zink, Zinn, Blei, Eisen, Gold, Palladium, Rhodium, Platin, Silber und Cadmium.

In der vorliegenden Anmeldung steht der Begriff "chemisches Metallabscheideverfahren" für ein Verfahren zum Herstellen einer Metallschicht auf einer Unterlage mit einem galvanotechnischen Verfahren, bei dem die Metallschicht aus einer chemischen Behandlungsflüssigkeit, beispielsweise einer Lösung, Suspension oder Dispersion, ohne Anwendung eines elektrischen Stromes auf der Werkstückoberfläche gebildet wird. Es wird unterschieden zwischen (außen)stromlosen/autokatalytischen Verfahren, bei denen zur Metallabscheidung Reduktionsmittel für die Reduktion von Metallionen zu Metall unter Bildung der Metallschicht verwendet werden, und zementativen Verfahren, bei denen keine derartigen Reduktionsmittel eingesetzt werden. Bei den stromlosen Verfahren ist die Abscheidungsflüssigkeit gegen Zersetzung metastabil. Bei den zementativen Verfahren werden die Metallionen durch einen Ladungsaustausch zwischen diesen und einer metallischen Unterlage, auf der die Metallschicht abgeschieden wird, reduziert, indem das Metall der Unterlage durch Oxidation aufgelöst und die Metallionen unter Reduktion abgeschieden werden (Abscheidung durch Ladungsaustauschreaktion). Beispielsweise können Nickel und dessen Legierungen mit Metalloiden sowie Kupfer stromlos abgeschieden werden. Als Reduktionsmittel dienen Hypophosphitsalze und deren Säure, Dimethylaminboran und Natriumborhydrid sowie Formaldehyd. Eine bevorzugte stromlose Nickelabscheidelösung enthält ein Nickelsalz, beispielsweise Nickelsulfat, und Natriumhypophosphit als Reduktionsmittel. Ferner kann beispielsweise Zinn mit einem zementativen Verfahren auf Kupferoberflächen abgeschieden werden, wenn die Abscheidelösung Thioharnstoff enthält. In diesem Falle löst sich Kupfer auf, und Zinn scheidet sich ab.

### Beschreibung der Erfindung:

Die vorliegende Erfindung betrifft ein Verfahren zum Fügen von mindestens zwei Werkstücken, die aus Edelstahl, Nickel oder Nickellegierungen bestehen gemäß Anspruch 1.

Gemäß einem zweiten Aspekt betrifft die vorliegende Erfindung ein Verfahren zum Herstellen eines mikrostrukturierten Bauteils, ausgewählt aus der Gruppe, umfassend Mikroreaktoren, Mikrowärmetauscher und Mikromischer (siche Anspruch 21). Es umfasst folgende Verfahrensschritte:
a) Durchführen des erfindungsgemäßen Fügeverfahrens für die Werkstücke, wobei die Werkstücke vor Verfahrensschritt c), insbesondere vor Bilden der Fügeschicht auf den Werkstücken (Verfahrensschritt b), mit Vertiefungen zur Bildung von Durchführungen versehen werden;
b) Vorsehen von Anschlussmitteln zum Ein- und Auslass von Fluiden in die Durchführungen hinein bzw. aus den Durchführungen heraus.

Die Werkstücke sind in diesem Falle vorzugsweise Metallfolien oder Metallbleche. Die mit der Fügeschicht versehenen Metallfolien oder Metallbleche werden in einem Stapel angeordnet und dann gefügt. An den Außenseiten weist der Stapel Außenfolien oder Außenbleche (Außenlagen) und dazwischen Innenfolien oder Innenbleche (Innenlagen) auf. Die eine Außenfolie oder das eine Außenblech ist eine Bodenfolie bzw. ein Bodenblech, und die andere Außenfolie oder das andere Außenblech ist eine Deckfolie bzw. ein Deckblech. Die Vertiefungen in den Werkstücken bilden nach dem Verbinden der Werkstücke die Durchführungen. Die Anschlussmittel zum Ein-und Auslassen von Fluiden in die Durchführungen hinein bzw. aus den Durchführungen heraus können insbesondere Anschlussstutzen sein, an die Schläuche, Rohre, Kapillaren oder andere externe Flüssigkeitsführungen angeschlossen werden können.

In einer bevorzugten erfindungsgemäßen Ausführungsform wird die Fügeanordnung auf eine Fügetemperatur im Bereich von 880 - 1200°C aufgeheizt. Die Fügetemperatur richtet sich zum einen nach der Art des Grundmaterials der Werkstücke und zum anderen nach der Art des Lotmaterials. Da das Lotmaterial eine Nickel/Phosphor-Legierung ist, liegt die gewählte Fügetemperatur über dem Schmelzpunkt der Nickel/Phosphor-Legierung (ca. 880°C für eine Legierung mit einem Phosphorgehalt von 11,5 Gew.-%). Der gewählte Temperaturbereich stellt einen Kompromiss zwischen der Forderung dar, die Fügetemperatur einerseits so hoch wie möglich zu wählen, um eine schnelle Diffusion der Lotbestandteile in die Werkstücke und des Werkstückmaterials in die Lotnaht zu ermöglichen, und andererseits nur so hoch wie nötig, um eine Schädigung der Werkstücke zu vermeiden, die darin bestehen kann, dass sich bei zu hoher Fügetemperatur Risse im Gefüge des Grundmaterials der Werkstücke bilden können und sich das Grundmaterial durch lokale Überhitzung verformen bzw. verziehen kann.

Mit dem erfindungsgemäßen Verfahren wird eine Fügetechnik bereitgestellt, die die Nachteile der bekannten Fügeverfahren hinsichtlich mechanischer Stabilität und Korrosionsbeständigkeit nicht aufweist. Ohne dadurch hinsichtlich der Tragweite der Erfindung beschränkt zu sein, wird vermutet, dass die überraschend hohe Beständigkeit der mit dem erfindungsgemäßen Verfahren hergestellten Bauteile dadurch erreicht werden kann, dass die Fügeschicht dünn ist und dass daher bei den erfindungsgemäß gewählten Lötbedingungen ein weitgehend monolithischer Verbund der Fügeschicht mit dem Edelstahl-, Nickel- oder Nickellegierungsgrundmaterial gebildet wird, ohne die Eigenschaften des Grundmaterials negativ zu beeinflussen.

Die speziell abgestimmten Lötparameter gemäß dem erfindungsgemäßen Verfahren sind insbesondere die Aufheizrate der Fügeanordnung auf die Fügetemperatur, der Anpressdruck sowie die Abkühlrate nach dem Fügen.

In einer erfindungsgemäßen Variante wird die Fügeanordnung zunächst auf eine Vorhaltetemperatur in einem Bereich von 700 - 900°C, die kleiner ist als die Fügetemperatur sowie kleiner als die Schmelztemperatur der Fügeschicht, und dann auf die Fügetemperatur aufgeheizt. Dies dient insbesondere dazu, die Fügeanordnung danach möglichst gleichmäßig auf die Fügetemperatur aufzuheizen. Um dies so gut wie möglich zu gewährleisten, kann die Fügeanordnung auf der Vorhaltetemperatur solange gehalten werden, bis die gesamte Fügeanordnung die Vorhaltetemperatur (in einem Fügeofen) erreicht hat. Diese Verweilzeit kann in einem Bereich von 0-3 h liegen. Daher kann die Fügeanordnung auch unmittelbar nach dem Erreichen der Vorhaltetemperatur weiter bis zur Fügetemperatur aufgeheizt werden, ohne bei der Vorhaltetemperatur zu verweilen. In einer bevorzugten Variante dieser Ausführungsform wird die Fügeanordnung mit einer Aufheizrate von 5 - 30 K/min auf die Vorhaltetemperatur aufgeheizt. Nach dem Erreichen der Vorhaltetemperatur wird die Anordnung mit einer weiteren Aufheizrate, die vorzugsweise kleiner ist als die Aufheizrate zum Erreichen der Vorhaltetemperatur, bis auf die Fügetemperatur aufgeheizt. Es hat sich gezeigt, dass die Materialeigenschaften der Fügeanordnung durch diesen zusätzlichen Schritt weiter verbessert werden können.

Die Fügeschicht wird erfindungsgemäß entweder mit einem chemischen oder elektrolytischen Verfahren gebildet. Es hat sich herausgestellt, dass die Fügeschicht vorzugsweise mit einem stromlosen Metallabscheideverfahren gebildet wird. Diese Verfahrensweise hat sich als vorteilhaft herausgestellt, weil dünne Metallschichten mit sehr gleichmäßiger Metallschichtdicke vor allem mit diesem Verfahren gebildet werden können. Mit elektrolytischen Verfahren können sehr dünne Schichten zwar ebenso hergestellt werden. Jedoch hängt die Gleichmäßigkeit von geometrischen Randbedingungen beim Abscheideverfahren ab, insbesondere von der Anordnung des Werkstückes im Abscheidebad und vor allem von dessen Anordnung relativ zur Anordnung der Gegenelektrode sowie von der Form des Werkstückes und der Anordnung und den Dimensionen von Vertiefungen auf dem Werkstück.

Das erfindungsgemäße Fügeverfahren wird zum Fügen von Werkstücken aus Edelstahl, Nickel und Nickellegierungen eingesetzt, wobei vorzugsweise Nickel-Superlegierungen, d.h. Nickel-Basislegierungen mit einem Nickelanteil von mindestens 28 Gew.-%, besonders bevorzugt in einem Bereich von 50 - 90 Gew.-%, am meisten bevorzugt in einem Bereich von 50 - 80 Gew.-%, eingesetzt werden. Besonders geeignete Nickel-Superlegierungen enthalten weniger als 50 Gew.-% Eisen. Die genannten Materialien eignen sich vor allem für die Herstellung mikrostrukturierter Bauteile. Diese Eignung verdanken diese Materialien ihrer thermischen und Korrosionsstabilität.

Beim erfindungsgemäßen Verfahren werden die Werkstücke ohne Lötspalt über eine Fügeschicht miteinander verbunden. Die Fügeschicht dient zur Erzeugung eines innigen Verbundes zwischen den Werkstückoberflächen. Durch die Verwendung der Fügeschichten kann insbesondere dann eine sehr feste Fügeverbindung erzielt werden, wenn die Bestandteile der Fügeschicht in die Fügepartner, die Werkstücke, diffundieren und auch dann, wenn die Bestandteile der Werkstücke in die Fügeschicht diffundieren. Dies wird durch das erfindungsgemäße Verfahren gewährleistet.

Die Aufbringung der Fügeanordnung erfolgt vorzugsweise mit einer der beiden folgenden Verfahrensvarianten:

Die Werkstücke werden vorzugsweise in einem Stapel angeordnet und sind Innenlagen und diese einfassende Außenlagen mit mit den Innenlagen in Kontakt stehenden Innenseiten.

In einer ersten bevorzugten Verfahrenvariante werden jeweils mindestens eine metallische Fügeschicht vollflächig auf jeweils mindestens einer Seite der Innenlagen und jeweils mindestens eine metallische Fügeschicht nur auf den Innenseiten der Außenlagen gebildet.

Um die Außenseite einer Außenlage in dieser Ausführungsform vor dem Abscheiden der Fügeschicht zu schützen, kann ein Resist auf diese Seite aufgebracht werden, so dass sich dort keine Fügeschicht abscheidet. Nach der Bildung der Fügeschicht ausschließlich auf der Innenseite der Außenlage wird der Resist wieder entfernt (gestrippt).

In einer zweiten bevorzugten Verfahrensvariante wird jeweils mindestens eine metallische Fügeschicht vollflächig auf jeweils mindestens einer Innenlage gebildet, und auf den Außenlagen wird keine Fügeschicht gebildet.

Durch Platzieren der Fügeschicht zwischen den Werkstücken und insbesondere durch Bilden der Fügeschicht mit einem chemischen oder elektrolytischen Verfahren auf den Oberflächen der Werkstücke können äußerst ebene und glatte Oberflächen der Werkstücke erzeugt werden. Dies ist für eine schnelle und feste Verbindung der Werkstücke miteinander äußerst vorteilhaft. Selbst wenn die Oberflächen der Werkstücke vor dem Aufbringen der Fügeschicht nicht äußerst eben und glatt sind, können die Fügeflächen durch geeignete Verfahrensführung die gewünschten Eigenschaften erhalten. Die Verfahrensbedingungen, die zur Erzeugung der gewünschten Eigenschaften benötigt werden, sind bekannt (Wahl geeigneter chemischer Behandlungslösungen, die eine sog. einebende Wirkung haben). Insbesondere können mit chemischen und elektrolytischen Verfahren selbst dann sehr ebene und glatte Oberflächen erzeugt werden, wenn die unbeschichteten Werkstückoberflächen nicht diesen Anforderungen genügen. Vorteilhaft ist auch, dass mit diesen Verfahren insbesondere auch dünne (wenige µm dicke) Schichten problemlos gebildet werden können.

Bei dem erfindungsgemäßen Verfahren entstehen im Wesentlichen monolithisch gefügte Bauteile, d.h. Bauteile, bei denen keine Fügenaht mehr sichtbar ist, da keine Grenzflächen mehr vorhanden sind. Somit unterscheidet sich der Bereich, in dem sich die Fügeschicht vor Durchführung des Fügeverfahrens befunden hat, nach dessen Durchführung nicht mehr oder nicht mehr wesentlich vom Grundmaterial und hat damit im Wesentlichen dieselben Eigenschaften wie das Grundmaterial. Vereinzelt können je nach Wahl der Lötbedingungen in geringem Umfange intermetallische Phasen gebildet werden, die jedoch keine zusammenhängende Naht bilden und unterhalb der kritischen Phasenausdehnung von 100 µm liegen. Ein solcher monolithischer Aufbau weist die geforderte hohe mechanische Dauerfestigkeit selbst unter thermischer Belastung auf sowie die gewünschte Widerstandsfähigkeit gegen Korrosion. Die hohe Festigkeit insbesondere auch unter thermischer Belastung wird in diesem Falle vor allem dadurch erreicht, dass sich die Ausdehnungskoeffizienten der einzelnen ursprünglich im Sandwich vorliegenden Materialien während des Diffusionsvorganges aneinander angleichen, so dass im Falle eines nahtlosen Verbundes praktisch kein Gradient des Ausdehnungskoeffizienten mehr vorliegt.

Die Fügetemperatur liegt erfindungsgemäß oberhalb der Schmelztemperatur der Fügeschicht. Die Fügetemperatur hängt naturgemäß vom Diffusionskoeffizienten der jeweiligen Komponente und somit von der Schmelztemperatur des Fügematerials ab; sie ist aber auch von der Schmelztemperatur des Grundmaterials der Werkstücke abhängig. Im Falle einer amorphen Legierung von 11,5 Gew.-% Phosphor in Nickel für die metallische Fügeschicht liegt deren Schmelzpunkt bei etwa 880°C. Die bevorzugte Fügetemperatur beträgt in diesem Fall 1050 -1150°C.

Die Fügeschicht weist vorzugsweise eine Dicke in einem Bereich von 0,5 - 10 µm auf, insbesondere bevorzugt 2 - 5 µm und am meisten bevorzugt 1 - 2 µm. Durch die Wahl einer geringen Dicke wird die Bildung von Sprödphasen unterdrückt. Da die Fügeschicht erfindungsgemäß sehr dünn ist, diffundieren die Legierungsbestandteile der Fügeschicht in die an die Fügeflächen der Werkstücke angrenzenden Bereiche. Wegen der kurzen Diffusionsstrecke findet die Diffusion schon in kurzer Zeit statt, so dass sehr schnell ein inniger Verbund der Werkstücke mit dem Fügematerial entsteht. Danach geht das Fügematerial bei ausreichend langer Fügedauer zumindest weitgehend im Werkstückmaterial auf. Da wegen der geringen Schichtdicke nur in relativ geringer Menge Fügematerial zur Verfügung steht, brauchen naturgemäß nur sehr geringe Mengen der Bestandteile des Fügematerials in die Werkstücke zu diffundieren. Es können auch Bestandteile des Materials, aus dem die zu fügenden Werkstücke bestehen, in die Fügenaht diffundieren, so dass insgesamt eine Interdiffusion der Elemente stattfindet.

Um aus den Fügepartnern ein monolithisches oder annähernd monolithisches Bauteil herzustellen, d.h. ein Bauteil mit einem nahtlosen oder weitgehend nahtlosen Fügeverbund, können die Werkstücke der Fügeanordnung mindestens so lange bei der Fügetemperatur gefügt werden, bis die Fügeschicht in einem Querschliff kaum noch oder überhaupt nicht mehr sichtbar gemacht werden kann. In einem derartigen Fall sind alle Fügenähte durch Diffusion der Bestandteile der Fügeschicht und der Fügepartner vollständig oder nahezu vollständig verschwunden. Dadurch wird ein hochfester und gegen Korrosion unempfindlicher Verbund gebildet.

Die Fügedauer zum Herstellen des Bauteils ist abhängig von der Art des Materials, aus dem die Werkstücke bestehen, und des Materials, aus dem die Fügeschicht besteht, ferner von der Fügetemperatur und dem Pressdruck, mit dem die Fügepartner während des Fügevorganges zusammengepresst werden. Die Fügedauer beträgt in dem erfindungsgemäßen Verfahren bevorzugt 15 min bis 4 Stunden. Besonders bevorzugt ist eine Fügedauer in einem Bereich von 45 - 90 min. Je höher die Fügetemperatur ist, desto geringer kann auch die Fügedauer sein.

Eine Optimierung der mechanischen Festigkeit des Verbundes wird ferner dadurch erreicht, dass die Fügeanordnung während der Erwärmung (Aufheizung und/oder Haltephase während des Fügens bei der Fügetemperatur) einem erhöhten Pressdruck ausgesetzt wird. Dadurch können noch kleinste Unebenheiten an den Fügeflächen ausgeglichen werden. Der Pressdruck liegt im Bereich von mindestens 10 kPa, bevorzugt im Bereich von 20 - 300 kPa.

Die Aufheiz- und Abkühlraten nehmen ebenfalls maßgeblich Einfluss auf die intermetallische Phasenbildung, die Alterung und die Korngröße in dem Werkstoffgefüge. Die relativ schnelle Abkühlung dient zur Minderung des Kornwachstums und sollte hierbei auf die Reduktion des Aufbaus innerer Spannung im Gefüge des Bauteils abgestimmt sein. Die Abkühlrate liegt daher erfindungsgemäß in einem Bereich von 10-100 K/min, vorzugsweise von 15-25 K/min.

Insbesondere bei der Herstellung von mikrostrukturierten Bauteilen aus Bauteillagen können die Werkstücke jeweils mindestens einen Fügebereich aufweisen, in dem eines der Werkstücke mit einem anderen gefügt werden kann. Die Fügepartner werden dann über jeweils einen oder mehrere aneinander anliegende Fügebereiche auf den Bauteillagen miteinander verbunden. In diesem Falle hat es sich als vorteilhaft erwiesen, die Fügeschicht lediglich an den Stellen in der Fügeanordnung zu platzieren (in den Fügebereichen), an denen die Bauteile über Fügeflächen miteinander verbunden werden sollen. Die Fügeschicht wird demnach selektiv nur auf die Fügeflächen (in den Fügebereichen) der Fügepartner aufgebracht, nicht jedoch auf an dere Oberflächen der Werkstücke. Um die Fügeschicht selektiv nur in den Fügebereichen zu bilden, kann eine Resisttechnik eingesetzt werden, bei der die Bereiche auf den Werkstücken, die nicht den Fügebereichen entsprechen, von dem Resist abgedeckt werden und die Fügeschicht dann in den freiliegenden (Füge)Bereichen gebildet wird. Der Resist kann danach wieder entfernt werden.

Die nachfolgend beschriebenen Beispiele und Figuren erläutern die Erfindung im Detail.
- Fig. 1: zeigt eine schematische Darstellung des Temperaturverlaufes während des Fügeverfahrens;
- Fig. 2: zeigt eine rasterelektronenmikroskopische Aufnahme einer Fügezone eines gefügten Probenzylinders aus Hastelloy^{®} C-4 gemäß Ausführungsbeispiel 1;
- Fig. 3: zeigt eine lichtmikroskopische Aufnahme einer Fügezone eines gefügten Bauteils aus Hastelloy^{®} C-4 gemäß Ausführungsbeispiel 2;
- Fig. 4: zeigt eine lichtmikroskopische Aufnahme der Fügezone von gefügten Blechstreifen aus reinem Nickel gemäß Ausführungsbeispiel 3;
- Fig. 5: zeigt eine lichtmikroskopische Aufnahme einer der Fügenzonen eines gefügten Bauteils aus Edelstahl (1.4404) gemäß Ausführungsbeispiel 4;
- Fig. 6: zeigt eine lichtmikroskopische Aufnahme einer der Fügezonen eines gefügten Bauteils aus Hastelloy^{®} C-4 gemäß Ausführungsbeispiel 5;
- Fig. 7: zeigt einen vergrößerten Ausschnitt aus Fig. 6 mit zwei beispielhaften Messungen der Größe von Ausscheidungen;
- Fig. 8: zeigt eine schematische Darstellung von Kanalblechen eines mikrostrukturierten Bauteils mit einseitiger Beschichtung des Boden- und des Deckbleches mit Fügeschichten (erste Ausführungsform);
- Fig. 9: zeigt eine schematische Darstellung von Kanalblechen eines mikrostrukturierten Bauteils ohne Beschichtung des Boden- und des Deckbleches mit Fügeschichten (zweite Ausführungsform).

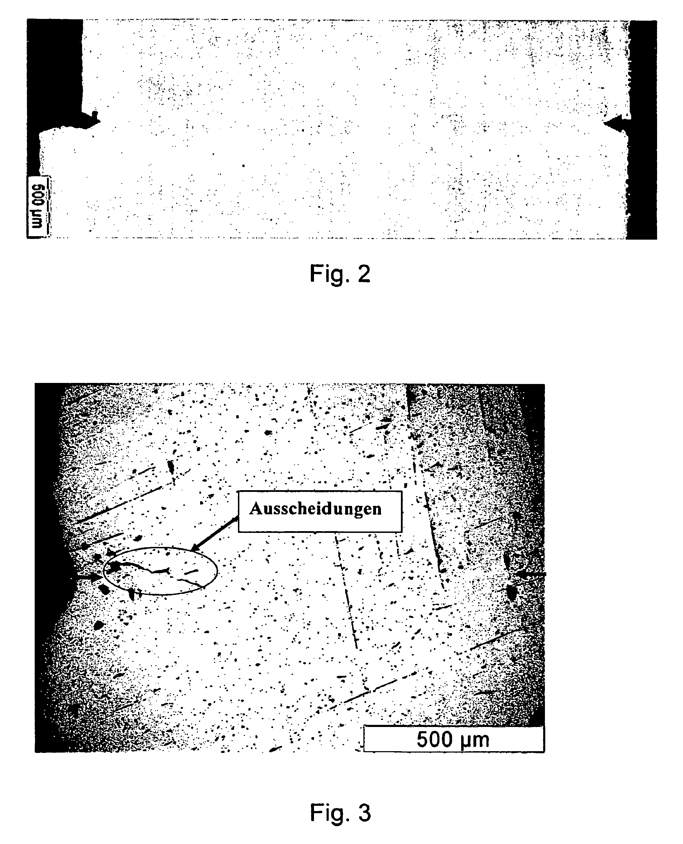

In den Fig. 2-6 zeigen die waagerechten Pfeile jeweils die Position der ehemaligen Fügeschicht aus der Nickel/Phosphor-Legierung.

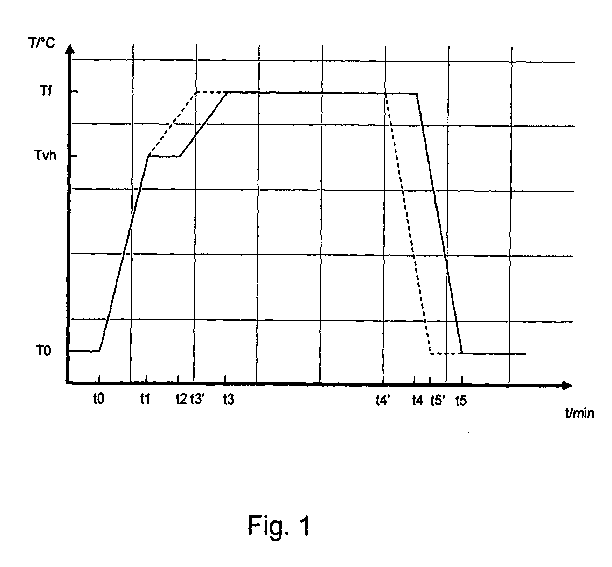

In Fig. 1 ist ein typischer Temperaturverlauf beim Fügen von Werkstücken schematisch wiedergegeben. Die Darstellung ist ein Graph mit einer Ordinate als Temperaturachse [T/°C] und einer Abszisse als Zeitachse [t/min]. Ausgehend von einer Starttemperatur T₀, die üblicherweise Raumtemperatur ist, zum Zeitpunkt t₀ wird eine Fügeanordnung zunächst mit einer vorgegebenen Aufheizrate bis auf eine Vorhaltetemperatur Tᵥₕ aufgeheizt. Die Fügeanordnung erreicht die Vorhaltetemperatur Tᵥₕ zum Zeitpunkt t₁. Wird die Fügeanordnung bei der Vorhaltetemperatur Tᵥₕ während einer Verweilzeit t₂-t₁ gehalten, so folgt der Verlauf der durchgezogenen Linie in Fig. 1. Wird die Fügeanordnung dagegen nach dem Erreichen der Vorhaltetemperatur Tᵥₕ sofort weiter bis zur Fügetemperatur T_{f} aufgeheizt, so folgt der Temperaturverlauf der strichlierten Linie. Nach dem Erreichen der Fügetemperatur T_{f} zum Zeitpunkt t₃ (wenn die Anordnung während des Zeitraumes t₂-t₁ bei der Vorhaltetemperatur Tᵥₕ verweilt hat) bzw. bereits zum Zeitpunkt t_{3'} (wenn die Anordnung nach dem Erreichen der Vorhaltetemperatur Tᵥₕ sofort weiter bis zur Fügetemperatur T_{f} aufgeheizt worden ist), wird die Anordnung bei dieser Temperatur gehalten, bis der Fügevorgang zum Zeitpunkt t₄ (wenn die Anordnung während des Zeitraumes t₂-t₁ bei der Vorhaltetemperatur Tᵥₕ verweilt hat) bzw. zum Zeitpunkt t₄, (wenn die Anordnung nach dem Erreichen der Vorhaltetemperatur Tᵥₕ sofort weiter bis zur Fügetemperatur T_{f} aufgeheizt worden ist) abgeschlossen ist. Zum Zeitpunkt t₄ bzw. t₄, startet die Abkühlphase. Die Fügeanordnung wird mit einer vorgegebenen Abkühlrate wieder abgekühlt und erreicht die Temperatur T₀ zum Zeitpunkt t₅ (wenn die Anordnung während des Zeitraumes t₂-t₁ bei der Vorhaltetemperatur Tᵥₕ verweilt hat) bzw. zum Zeitpunkt t_{5'} (wenn die Anordnung nach dem Erreichen der Vorhaltetemperatur Tᵥₕ sofort weiter bis zur Fügetemperatur T_{f} aufgeheizt worden ist).

### A. Versuchsbedingungen:

### a. Grundmaterialien und Probendesigns:

Mit dem erfindungsgemäßen Fügeverfahren können prinzipiell Edelstähle, verschiedenste Nickellegierungen sowie reines Nickel gefügt werden Beispielhaft wurden Fügeversuche mit Blechstreifen, Probenzylindern sowie Bauteilen aus Edelstahl (Werkstoffnummer 1.4404), der Nickellegierung Hastelloy^{®} C-4 (Werkstoffnummer 2.4610) und reinem Nickel durchgeführt.

### b. Erzeugung der Fügeschichten durch Metallabscheidung:

NiPₓ-Schichten mit einer Schichtdicke von 3 - 5 µm wurden mit einem stromlosen Metallisierungsbad abgeschieden. Hierzu wurde das Bad NiChem PF 500 (Atotech Deutschland) verwendet (Ni-Gehalt: 5,6 g/l, Natriumhypophosphit als Reduktionsmittel, T: 82 - 90°C, pH: 4,6 - 4,9, Phosphorgehalt der abgeschiedenen Schicht: x = 7 - 14 Gew.-%).

Zur Beschichtung der Proben mit NiPₓ wurden diese zuvor mit den in den Tabellen 1 und 2 angegebenen Verfahren vorbehandelt. Die dort genannten Bäder Uniclean^{®} (Marke von Atotech Deutschland, DE) 155 (Heißentfettung), Uniclean^{®} 675 (saure Beize/Aktivierung), Uniclean^{®} 279 sowie Nonacid^{®} (Marke von Atotech Deutschland, DE; beides elektrolytische Entfettungsbäder) sind Produkte von Atotech Deutschland. Das Nickelstrikebad ist ein handelsübliches elektrolytisches Nickelbad (Watts-Typ), mit dem eine hoch aktive Nickelschicht auf die Metallprobe aufgebracht wird, um die Oberfläche für die anschließende Beschichtung vorzubereiten. Ohne diese Vor-Vernickelung kann weder Nickel noch NiPₓ auf das passive Material aufgebracht werden.

**Tabelle 1: Verfahren für die Vorbehandlung von Edelstahl (1.4404) für die NiPₓ-Beschichtung**

| Bad | pH-Wert | Temperatur [°C] | Stromdichte [A/dm²] | Behandlungsdauer [Minuten] |
|---|---|---|---|---|
| Uniclean^{®} 155 (6%) | ≈ 14 | 60 | ./. | 10 |
| Nonacid^{®} 701 | ≈ 13 | 55 | 7 - 15 | 2 |
| Nickelstrike | ≈ 1 | 40 | 1 | 1 |

**Tabelle 2: Verfahren für die Vorbehandlung von Hastelloy® C-4 und Nickel für die NiPₓ-Beschichtung**

| Bad | pH-Wert | Temperatur [°C] | Stromdichte [A/dm²] | Behandlungsdauer [Minuten] |
|---|---|---|---|---|
| Uniclean^{®} 155 (6%) | = 14 | 60 | . / . | 10 |
| Uniclean^{®} 675 | = 1 | RT | - | 1 |
| Uniclean^{®} 279 | = 13 | 40 | 5 - 15 | 2 |
| Nickelstrike | ≈ 1 | 40 | 1 | 1 |

Die Dicke der jeweiligen Schichten wurde mittels XRF (Röntgenfluoreszenzspektroskopie) sowie durch Herstellung eines Querschliffes und dessen optische Begutachtung unter einem Lichtmikroskop oder Rasterelektronenmikroskop ermittelt.

### c. Fügevorgang:

Die mit den jeweiligen Fügeschichten versehenen Proben wurden in einem Wärmebehandlungsofen mit den in den Beispielen angegebenen Parametern gefügt. Nach dem Erwärmen der Proben auf die Fügetemperatur wurden diese während eines Haltezeitraumes auf der Fügetemperatur gehalten. Zur Fixierung der Proben wurden Graphithalter verwendet. Zur Trennung der metallischen Proben vom Haltermaterial dienten Keramik-Platten bzw. Bornitrid-Spray. Der erforderliche Anpressdruck wurde durch Auflegen von Gewichten mit entsprechender Masse aufgebracht.

### d. Qualität der Fügeverbindung:

Zur Bewertung der Qualität der Fügeverbindungen wurden jeweils Querschliffe über die Fügezonen hinweg präpariert und mittels optischer bzw. Rasterelektronenmikroskopie untersucht. Gefügte Bauteile wurden zusätzlich mit Luftdruck (3 bar) auf Dichtigkeit untersucht. Anschließend wurde der maximale hydrostatische Berstdruck, dem die gefügten Bauteile standhielten, an einem Berststand ermittelt.

### B. Erfindungsgemäße Beispiele:

**Fügen A** (ohne Verweilzeit bei der Vorhaltetemperatur):

### Beispiel 1:

Fügen von Probenzylindern aus Hastelloy^{®} C-4:
- NiPₓ-Schichtdicke: 3 µm
- Anpressdruck: 1400 kPa
- Aufheizen mit 25 K/min auf 1100°C
- 4 h Halten bei 1100°C
- Abkühlen mit 25 K/min

Fig. 2 zeigt eine rasterelektronenmikroskopische Aufnahme der erhaltenen Fügezone. Es ist keine Grenzfläche zwischen den gefügten Zylindern zu erkennen. Es handelt sich daher um ein monolithisches Gefüge.

### Beispiel 2:

Fügen eines Bauteils aus Hastelloy^{®} C-4:
- NiPₓ-Schichtdicke: 4,4 µm
- Anpressdruck: 30 kPa
- Aufheizen mit 10 K/min auf 800°C
- weiteres Aufheizen mit 5 K/min auf 1100°C
- 1 h Halten bei 1100°C
- Abkühlen mit 25 K/min

Fig. 3 zeigt eine lichtmikroskopische Aufnahme der erhaltenen Fügezone. Neben monolithischen Bereichen (rechte Seite) sind auch vereinzelt kleine Ausscheidungen (linker Rand) zu sehen. Diese kleinen inselartigen Ausscheidungen beeinflussen die Materialeigenschaften nicht negativ. Bei den schwarzen Punkten der Abbildung handelt es sich um präparationsbedingte Artefakte. Derart gefügte Bauteile waren luftdicht und zeigten Berstwerte von mehr als 300 bar.

### Beispiel 3:

Fügen von Blechstreifen aus reinem Nickel:
- NiPₓ-Schichtdicke: 4,8 µm
- Anpressdruck: 30 kPa
- Aufheizen mit 10 K/min auf 800°C
- weiteres Aufheizen mit 5 K/min auf 1100°C
- 1 h Halten bei 1100°C
- Abkühlen mit 25 K/min

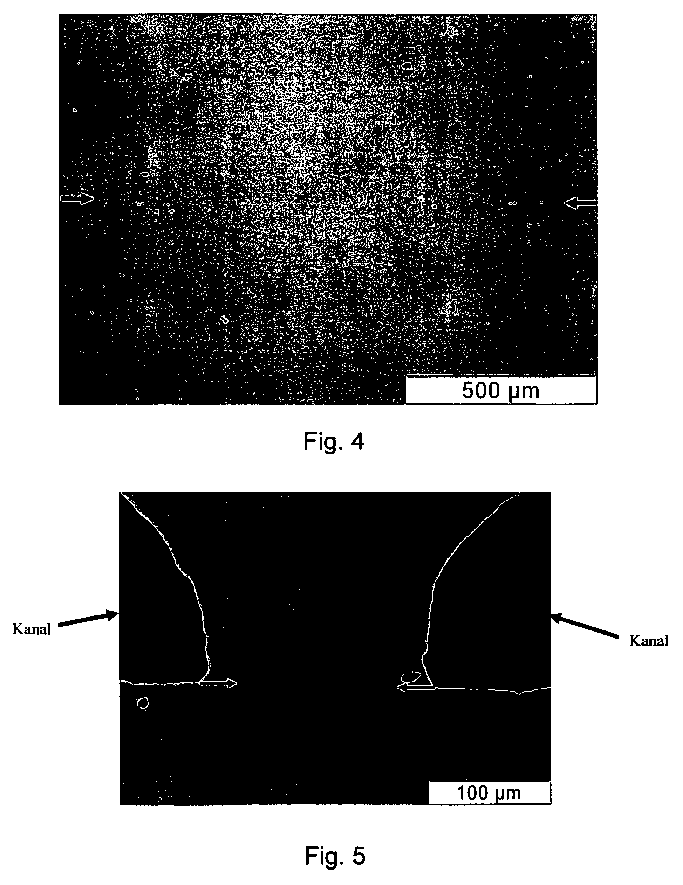

Fig. 4 zeigt eine lichtmikroskopische Aufnahme der Fügezone. Die Grenzfläche ist nicht mehr sichtbar. Es handelt sich daher um eine monolithische Fügenaht.

### Beispiel 4:

Fügen eines Bauteils aus Edelstahl (1.4404):
- NiPₓ-Schichtdicke: 4,5 µm
- Anpressdruck: 30 kPa
- Aufheizen mit 10 K/min auf 800°C
- weiteres Aufheizen mit 5 K/min auf 1100°C
- 1 h Halten bei 1100°C
- Abkühlen mit 25 K/min

Fig. 5 zeigt eine lichtmikroskopische Aufnahme einer der Fügenzonen. Es ist keine Grenzfläche erkennbar. Es handelt sich daher um ein monolithisches Gefüge. Die Berstwerte analog gefügter Bauteile lagen über 299 bar.

### Fügen B (mit Verweilzeit bei der Vorhaltetemperatur):

### Beispiel 5:

Fügen eines Bauteils aus Hastelloy^{®} C-4:
- NiPₓ-Schichtdicke: 4,5 µm
- Anpressdruck: 30 kPa
- Aufheizen mit 10 K/min auf 800°C
- 45 min Halten bei 800°C
- weiteres Aufheizen mit 5 K/min auf 1100°C
- 1 h Halten bei 1100°C
- Abkühlen mit 20 K/min

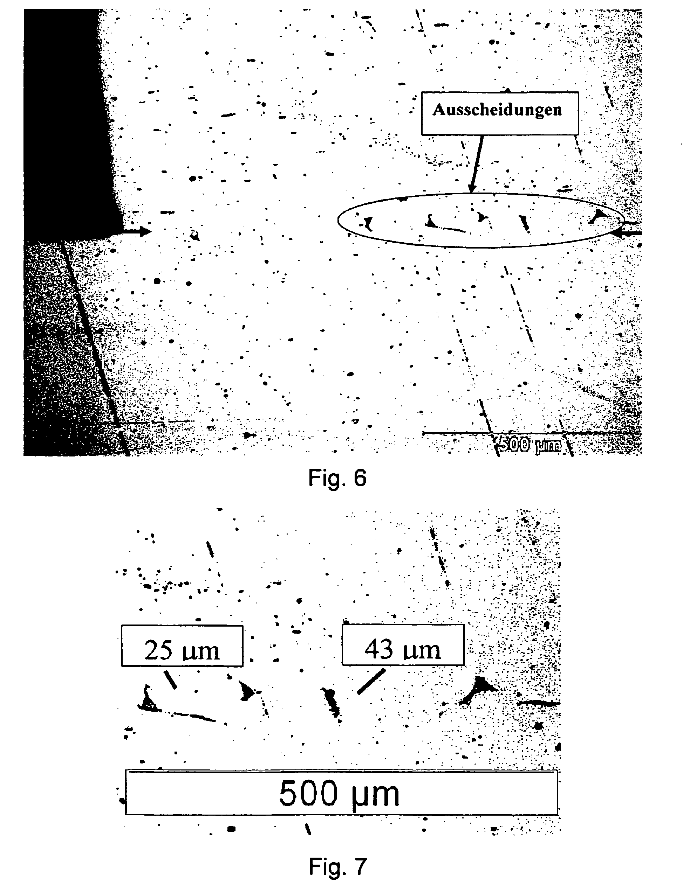

Fig. 6 zeigt eine lichtmikroskopische Aufnahme von einer der Fügezonen. Neben monolithischen Bereichen (linke Seite) sind kleine Ausscheidungen (rechte Seite) zu erkennen. Fig. 7 zeigt einen vergrößerten Ausschnitt aus Fig. 6 mit zwei beispielhaften Messungen der Größe von Ausscheidungen. Die Ausscheidungen sind deutlich kleiner als die kritische Phasenausdehnung von Sprödphasen. Ein derart gefügtes Bauteil hatte einen Berstwert von 207 bar.

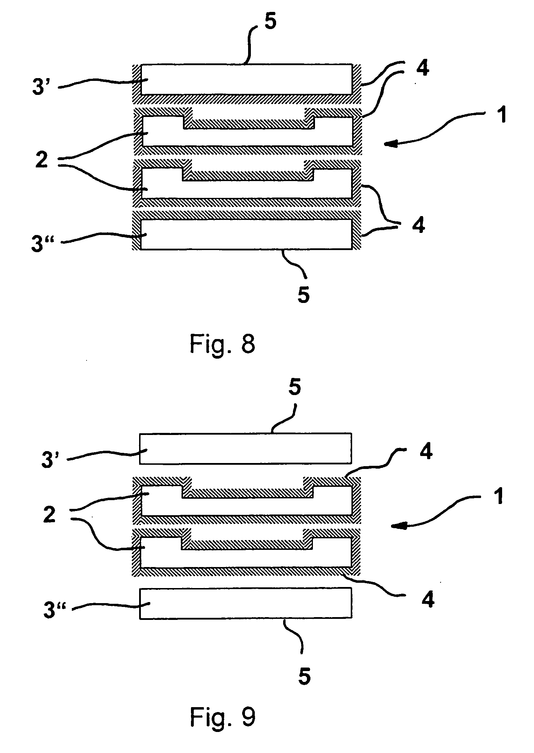

Die Fig. 8 und 9 zeigen schematische Darstellung von Stapeln 1 von mikrostrukturierten Kanalblechen 2 (Innenblechen) und jeweiligen Außenblechen 3', 3" für ein mikrostrukturiertes Bauteil im Schnitt. Die einzelnen Bleche 2, 3', 3" sind in Explosionsdarstellung gezeigt, um die aufgebrachten Fügeschichten 4 erkennen zu können. Die beiden Darstellungen unterscheiden sich hinsichtlich der Aufbringung von Fügeschichten (Lot) 4 auf die Innenbleche 2 und die Außenbleche 3', 3" im Stapel.

In einer ersten Verfahrensvariante gemäß Fig. 8 werden die inneren Kanalbleche 2 vollflächig beschichtet. Die Außenbleche (Bodenblech 3" und Deckblech 3') werden vor dem Beschichten mit der Fügeschicht 4 (graue Schraffierung) jeweils auf den Außenseiten 5 beispielsweise mittels eines Resists geschützt (nicht gezeigt), damit auf den äußeren Flächen keine Fügeschicht abgeschieden wird.

In einer zweiten Verfahrensvariante gemäß Fig. 9 werden nur die inneren Kanalbleche 2 vollflächig mit der Fügeschicht 4 (graue Schraffierung) versehen, während die Außenbleche (Bodenblech 3" und Deckblech 3') vollständig frei von der Fügeschicht bleiben. Es hat sich gezeigt, dass auch in dieser Variante ein fester Fügeverbund erhalten werden kann. Vorteil von Variante 2 ist die einfachere Prozessführung, da das Bodenblech 3" und das Deckblech 3' weder mit einer Fügeschicht versehen sind, noch ein Resist aufgebracht werden muss.

## Patentansprüche

1. Verfahren zum Fügen von mindestens- zwei Werkstücken (2, 3) aus Edelstahl, Nickel oder Nickellegierungen, umfassend folgende Verfahrensschritte:
a) Bereitstellen der mindestens zwei Werkstücke (2, 3);
b) Bilden jeweils einer metallischen Fügeschicht (4) auf mindestens einer Seite mindestens eines der mindestens zwei Werkstücke (2, 3) mit einem chemischen oder elektrolytischen Metallabscheideverfahren, wobei die metallische Fügeschicht (4) aus einer Nickel/Phosphor-Legierung besteht;
c) Bilden einer Fügeanordnung der Werkstücke (2, 3) derart, dass sich zwischen den mindestens zwei Werkstücken (2, 3) jeweils mindestens eine metallische Fügeschicht (4) befindet;
d) Aufheizen der Fügeanordnung auf eine Fügetemperatur oberhalb der Schmelztemperatur der metallischen Fügeschicht (4);
e) Fügen der mindestens zwei Werkstücke (2, 3) bei der Fügetemperatur unter Aufbringung eines Pressdruckes im Bereich von mindestens 10 kPa;
f) Abkühlen der Fügeanordnung,
**dadurch gekennzeichnet, dass** die metallische Fügeschicht (4) aus der Nickel/Phosphor-Legierung einen Phosphorgehalt in einem Bereich von 1-14 Gew.-% und eine Dicke in einem Bereich von 0,5 -10 µm hat, dass die Fügeanordnung mit einer Aufheizrate von 5-30 K/min auf die Fügetemperatur aufgeheizt und mit einer Abkühlrate in einem Bereich von 10-100 K/min abgekühlt wird.

2. Verfahren nach Anspruch 1, **dadurch gekennzeichnet, dass** die Nickellegierung eine Superlegierung mit weniger als 50 Gew.-% Eisengehalt ist.

3. Verfahren nach einem der vorstehenden Ansprüche, **dadurch gekennzeichnet, dass** die Nickellegierung einen Nickelgehalt von mindestens 28 Gew.-% hat.

4. Verfahren nach einem der vorstehenden Ansprüche, **dadurch gekennzeichnet, dass** mindestens eine Fügeschicht (4) eine Nickel/Phosphor-Legierung mit einem Phosphor-Gehalt in einem Bereich von 8-12 Gew.-% ist.

5. Verfahren nach einem der vorstehenden Ansprüche, **dadurch gekennzeichnet, dass** das chemische Metallabscheideverfahren ein stromloses Metallabscheideverfahren ist.

6. Verfahren nach einem der vorstehenden Ansprüche, **dadurch gekennzeichnet, dass** das stromlose Metallabscheideverfahren unter Verwendung eines Bades, enthaltend ein Nickelsalz und Natriumhypophosphit als Reduktionsmittel durchgeführt wird.

7. Verfahren nach einem der vorstehenden Ansprüche, **dadurch gekennzeichnet, dass** mindestens eine metallische Fügeschicht (4) eine Dicke in einem Bereich von 2 - 5 µm hat.

8. Verfahren nach einem der vorstehenden Ansprüche, **dadurch gekennzeichnet, dass** mindestens eine metallische Fügeschicht (4) eine Dicke in einem Bereich von 1 - 2 µm hat.

9. Verfahren nach einem der vorstehenden Ansprüche, **dadurch gekennzeichnet, dass** die Fügetemperatur in einem Bereich von 1050 - 1150°C liegt.

10. Verfahren nach einem der vorstehenden Ansprüche, **dadurch gekennzeichnet, dass** die Fügeanordnung unter Aufbringung eines Pressdruckes in einem Bereich von 20 - 300 kPa gefügt wird.

11. Verfahren nach einem der vorstehenden Ansprüche, **dadurch gekennzeichnet, dass** die Fügeanordnung in Verfahrensschritt d) unter Aufbringung eines Pressdruckes im Bereich von mindestens 10 kPa aufgeheizt wird.

12. Verfahren nach einem der vorstehenden Ansprüche, **dadurch gekennzeichnet, dass** die Fügeanordnung während einer Dauer in einem Bereich von 15 min - 4 h gefügt wird.

13. Verfahren nach einem der vorstehenden Ansprüche, **dadurch gekennzeichnet, dass** die Fügeanordnung während einer Dauer von 45 - 90 min gefügt wird.

14. Verfahren nach einem der vorstehenden Ansprüche, **dadurch gekennzeichnet, dass** die Fügeanordnung mit einer Abkühlrate von 15 -25 K/min abgekühlt wird.

15. Verfahren nach einem der vorstehenden Ansprüche, **dadurch gekennzeichnet, dass** die Fügeanordnung zunächst auf eine Vorhaltetemperatur in einem Bereich von 700 - 900°C, die kleiner ist als die Fügetemperatur sowie kleiner als die Schmelztemperatur der Fügeschicht, und dann auf die Fügetemperatur aufgeheizt wird.

16. Verfahren nach Anspruch 15, **dadurch gekennzeichnet, dass** die Fügeanordnung mit einer Aufheizrate in einem Bereich von 5-30 K/min auf die Vorhaltetemperatur aufgeheizt wird.

17. Verfahren nach einem der vorstehenden Ansprüche, **dadurch gekennzeichnet, dass** die Werkstücke (2, 3) in einem Stapel (1) angeordnet sind und dass die Werkstücke Innenlagen (2) und diese einfassende Außenlagen (3) mit mit den Innenlagen (2) in Kontakt stehenden Innenseiten sind und dass jeweils mindestens eine metallische Fügeschicht (4) vollflächig auf jeweils mindestens einer Seite der Innenlagen (2) und jeweils mindestens eine metallische Fügeschicht (4) nur auf den Innenseiten der Außenlagen (3) gebildet werden.

18. Verfahren nach einem der Ansprüche 1-16, **dadurch gekennzeichnet, dass** die Werkstücke (2, 3) in einem Stapel (1) angeordnet sind und dass die Werkstücke Innenlagen (2) und diese einfassende Außenlagen (3) mit mit den Innenlagen (2) in Kontakt stehenden Innenseiten sind und dass jeweils mindestens eine metallische Fügeschicht (4) vollflächig auf jeweils mindestens einer Innenlage (2) gebildet wird und auf den Außenlagen (3) keine Fügeschicht (4) gebildet wird.

19. Verfahren nach einem der vorstehenden Ansprüche, **dadurch gekennzeichnet, dass** die mindestens zwei Werkstücke (2, 3) jeweils mindestens einen Fügebereich aufweisen, in dem eines der mindestens zwei Werkstücke (2, 3) mit einem anderen gefügt wird und dass jeweils mindestens eine metallische Fügeschicht (4) lediglich in dem mindestens einen Fügebereich gebildet wird.

20. Verfahren nach einem der vorstehenden Ansprüche, **dadurch gekennzeichnet, dass** die mindestens zwei Werkstücke (2, 3) so lange gefügt werden, bis die metallische Fügeschicht (4) in einem Querschliff im Wesentlichen nicht mehr sichtbar gemacht werden kann.

21. Verfahren zum Herstellen eines mikrostrukturierten Bauteils, ausgewählt aus der Gruppe, umfassend Mikroreaktoren, Mikrowärmetauscher und Mikromischer, umfassend folgende Verfahrensschritte:
a) Durchführen des Verfahrens nach einem der Ansprüche 1 - 20, wobei die Werkstücke (2, 3) vor Verfahrensschritt c) mit Vertiefungen zur Bildung von Durchführungen versehen werden;
b) Vorsehen von Anschlussmitteln zum Ein- und Auslass von Fluiden in die Durchführungen hinein bzw. aus den Durchführungen heraus.

## Claims

1. Method of joining at least two workpieces (2, 3) made of stainless steel, nickel or nickel alloys, the said method comprising the following method steps:
a) prepare the at least two workpieces (2, 3);
b) In each case form a metallic jointing layer (4) on at least one side at least of one of the at least two workpieces (2, 3) using a chemical or electrolytic metal deposition method, wherein the metallic jointing layer (4) comprises a nickel/phosphorous alloy;
c) form a jointing arrangement of the workpieces (2, 3) in such a manner that between the at least two workpieces (2, 3) in each case there is at least one metallic jointing layer (4);
d) heat up the jointing arrangement to a jointing temperature in excess of the melting temperature of the metallic jointing layer (4);
e) join the at least two workpieces (2, 3) at the jointing temperature by applying a compressive pressure within the range of at least 10 kPa;
f) cool the jointing arrangement,
**characterised in that** the phosphorous content of the metallic jointing layer (4) made of the nickel/phosphorous alloy is within a range of 1 - 14 % by weight and the thickness is within a range of 0.5 - 10 µm, **in that** the jointing arrangement is heated to the jointing temperature at a heating rate of 5 - 30 K/min and is cooled at a cooling rate within a range of 10 - 100 K/min.

2. Method according to claim 1, **characterised in that** the nickel alloy is a super alloy with less that 50% by weight iron content.

3. Method according to one of the preceding claims, **characterised in that** the nickel content of the nickel alloy is at least 28% by weight.

4. Method according to one of the preceding claims, **characterised in that** at least one jointing layer (4) is a nickel/phosphorous alloy with a phosphorous content within a range of 8 - 12 % by weight.

5. Method according to one of the preceding claims, **characterised in that** the chemical metal deposition method is an electroless metal deposition method.

6. Method according to one of the preceding claims, **characterised in that** the electroless metal deposition method is carried out using a bath containing a nickel salt and sodium hypophosphite as reducing agent.

7. Method according to one of the preceding claims, **characterised in that** the thickness of at least one metallic jointing layer (4) is within a range of 2 - 5 µm.

8. Method according to one of the preceding claims, **characterised in that** the thickness of at least one metallic jointing layer (4) is within a range of 1 -2 µm.

9. Method according to one of the preceding claims, **characterised in that** the jointing temperature is within a range of 1050 - 1150°C.

10. Method according to one of the preceding claims, **characterised in that** the jointing arrangement is joined by applying a compressive pressure within a range of 20 - 300 kPa.

11. Method according to one of the preceding claims, **characterised in that** the jointing arrangement is heated in method step d) when applying a compressive pressure within the range of at least 10 kPa.

12. Method according to one of the preceding claims, **characterised in that** the jointing arrangement is joined for a period within a range of 15 min - 4 h.

13. Method according to one of the preceding claims, **characterised in that** the jointing arrangement is joined for a period of 45 - 90 min.

14. Method according to one of the preceding claims, **characterised in that** the jointing arrangement is cooled at a cooling rate of 15-25 K/min.

15. Method according to one of the preceding claims, **characterised in that** the jointing arrangement is initially heated to a preliminary temperature within a range from 700 - 900°C, which is lower than the jointing temperature and lower than the melting temperature of the jointing layer, and is then heated to the jointing temperature.

16. Method according to claim 15, **characterised in that** the jointing arrangement is heated to the preliminary temperature at a heating rate within a range of 5 - 30 K/min.

17. Method according to one of the preceding claims, **characterised in that** the workpieces (2, 3) are disposed in a stack (1) and **in that** the workpieces are inner layers (2) and outer layers (3), which enclose the said Inner layers, with insides that are in contact with the inner layers (2), and **in that** in each case at least one metallic jointing layer (4) is formed over the entire surface of at least one side of the inner layers (2) and in each case at least one metallic jointing layer (4) is formed only on the insides of the outer layers (3).

18. Method according to one of claims 1-16, **characterised in that** the workpieces (2, 3) are disposed in a stack (1) and **in that** the workpieces are inner layers (2) and outer layers (3), which enclose the said inner layers, with insides that are in contact with the inner layers, and **in that** in each case at least one metallic jointing layer (4) is formed over the entire surface of at least one inner layer (2) and no jointing layer (4) is formed on the outer layers (3).

19. Method according to one of the preceding claims, **characterised in that** the at least two workpieces (2, 3) each include at least one jointing region, in which one of the at least two workpieces (2, 3) is joined to another and **in that** in each case at least one metallic jointing layer (4) is formed simply in the at least one jointing region.

20. Method according to one of the preceding claims, **characterised in that** the at least two workpieces (2, 3) are joined together until it is no longer substantially possible to see the metallic jointing layer (4) in a cross-section.

21. Method for producing a micro-structured component, selected from the group including micro-reactors, micro-heat exchangers and micro-mixers, the said method including the following method steps:
a) carry out the method according to one of claims 1 - 20, wherein before method step c) the workpieces (2, 3) are provided with indentations for forming passages:
b) provide connecting means for the inlet of fluids into the passages and the outlet of fluids out of the passages.

## Revendications

1. Procédé d'assemblage d'au moins deux pièces à usiner (2, 3) en acier inoxydable, en nickel ou des alliages de nickel, comprenant les étapes suivantes consistant à :
a) préparer au moins deux pièces à usiner (2, 3) ;
b) former une couche d'assemblage métallique (4) sur au moins un côté d'au moins une des au moins deux pièces à usiner (2, 3) avec un procédé de dépôt métallique chimique ou électrolytique, la couche d'assemblage métallique (4) étant constituée d'un alliage de nickel/phosphore ;
c) former une structure d'assemblage des pièces à usiner (2, 3) de cette manière, de sorte qu'il y ait chaque fois au moins une couche d'assemblage métallique (4) entre les au moins deux pièces à usiner (2, 3) ;
d) chauffer la structure d'assemblage à une température d'assemblage supérieure à la température de fusion de la couche d'assemblage métallique (4) ;
e) assembler les au moins deux pièces à usiner (2, 3) à la température d'assemblage en fournissant une pression dans la gamme d'au moins 10 kPa ;
f) refroidir la structure d'assemblage,
**caractérisé en ce que** la couche d'assemblage métallique (4) constituée de l'alliage de nickel/phosphore est dans une gamme de 1 à 14 % en poids et a une épaisseur dans une gamme de 0,5 à 10 µm, **en ce que** la structure d'assemblage est chauffée à une vitesse de chauffage de 5 à 30 K/min à la température d'assemblage et est refroidie avec une vitesse de refroidissement dans la gamme de 10 à 100 K/min.

2. Procédé selon la revendication 1, **caractérisé en ce que** l'alliage de nickel est un superalliage ayant une teneur en fer inférieure à 50 % en poids.

3. Procédé selon l'une quelconque des revendications précédentes, **caractérisé en ce que** l'alliage de nickel a une teneur en nickel d'au moins 28 % en poids.

4. Procédé selon l'une quelconque des revendications précédentes, **caractérisé en ce qu'**au moins une couche d'assemblage (4) est un alliage de nickel/phosphore avec une teneur en phosphore dans la gamme de 8 à 12 % en poids.

5. Procédé selon l'une quelconque des revendications précédentes, **caractérisé en ce que** le procédé de dépôt métallique chimique est un procédé de dépôt métallique autocatalytique.

6. Procédé selon l'une quelconque des revendications précédentes, **caractérisé en ce que** le procédé de dépôt métallique autocatalytique est effectué en utilisant un bain contenant un sel de nickel et de l'hypophosphite de sodium en tant que réducteur.

7. Procédé selon l'une quelconque des revendications précédentes, **caractérisé en ce qu'**au moins une couche d'assemblage métallique (4) a une épaisseur dans une gamme de 2 à 5 µm.

8. Procédé selon l'une quelconque des revendications précédentes, **caractérisé en ce qu'**au moins une couche d'assemblage métallique (4) a une épaisseur dans une gamme de 1 à 2 µm.

9. Procédé selon l'une quelconque des revendications précédentes, **caractérisé en ce que** la température d'assemblage se trouve dans une gamme de 1 050 à 1 150 °C.

10. Procédé selon l'une quelconque des revendications précédentes, **caractérisé en ce que** la structure d'assemblage est assemblée en fournissant une pression dans une gamme de 20 à 300 kPa.

11. Procédé selon l'une quelconque des revendications précédentes, **caractérisé en ce que** la structure d'assemblage à l'étape d) est chauffée en fournissant une pression dans la gamme d'au moins 10 kPa.

12. Procédé selon l'une quelconque des revendications précédentes, **caractérisé en ce que** la structure d'assemblage est assemblée en une durée dans une gamme de 15 min à 4 h.

13. Procédé selon l'une quelconque des revendications précédentes, **caractérisé en ce que** la structure d'assemblage est assemblée en une durée de 45 à 90 minutes.

14. Procédé selon l'une quelconque des revendications précédentes, **caractérisé en ce que** la structure d'assemblage est refroidie avec une vitesse de refroidissement de 15 à 25 K/min.

15. Procédé selon l'une quelconque des revendications précédentes, **caractérisé en ce que** la structure d'assemblage est tout d'abord chauffée à une température constante dans une gamme de 700 à 900 °C, laquelle est plus basse que la température d'assemblage et plus basse que la température de fusion de la couche d'assemblage, puis chauffée à la température d'assemblage.

16. Procédé selon la revendication 15, **caractérisé en ce que** la structure d'assemblage est chauffée avec une vitesse de chauffage dans une gamme de 5 à 30 K/min à la température constante.

17. Procédé selon l'une quelconque des revendications précédentes, **caractérisé en ce que** les pièces à usiner (2, 3) sont agencées en un empilement (1) et **en ce que** les pièces à usiner (2) sont des parties intérieures (2) et des parties extérieures (3) qui entourent les parties intérieures et qui ont des faces internes qui sont en contact avec les parties intérieures (2) et **en ce qu'**au moins une couche d'assemblage métallique (4) est formée chacune sur toute la surface d'au moins un côté des parties intérieures (2) et **en ce que** au moins une couche d'assemblage métallique (4) est formée seulement sur les faces internes des parties extérieures (3).

18. Procédé selon l'une quelconque des revendications 1 à 16, **caractérisé en ce que** les pièces à usiner (2, 3) sont agencées en un empilement (1) et **en ce que** les pièces à usiner (2) sont des parties intérieures (2) et des parties extérieures (3) qui entourent les parties intérieures et qui ont des faces internes qui sont en contact avec les parties intérieures (2) et **en ce qu'**au moins une couche d'assemblage métallique (4) est formée chacune sur toute la surface d'au moins une partie intérieure (2) et **en ce qu'**aucune couche d'assemblage (4) n'est formée sur les parties extérieures (3).

19. Procédé selon l'une quelconque des revendications précédentes, **caractérisé en ce que** les au moins deux pièces à usiner (2, 3) présentent chacune au moins une zone d'assemblage, dans laquelle une des au moins deux pièces à usiner (2, 3) est assemblée avec l'autre et **en ce qu'**au moins une couche d'assemblage métallique (4) est uniquement formée dans la au moins une zone d'assemblage.

20. Procédé selon l'une quelconque des revendications précédentes, **caractérisé en ce que** les au moins deux pièces à usiner (2, 3) sont assemblées aussi longtemps que la couche d'assemblage métallique (4) ne peut substantiellement plus être visible dans un polissage transversal.

21. Procédé de fabrication d'une pièce microstructurée, choisie dans le groupe comprenant les microréacteurs, les microéchangeurs thermiques et les micromélangeurs, comprenant les étapes suivantes consistant à :
a) réaliser le procédé selon l'une quelconque des revendications 1 à 20, les pièces à usiner (2, 3) avant l'étape c) étant dotées de creux pour former les réalisations ;
b) prévoir un moyen de connexion pour l'entrée et la sortie de fluides dans les réalisations ou hors des réalisations.
